**Europäisches Patentamt**

**European Patent Office**

**Office européen des brevets**

(19)

(11) Veröffentlichungsnummer: **0 090 255**
**B1**

(12)
# EUROPÄISCHE PATENTSCHRIFT

(45) Veröffentlichungstag der Patentschrift:
24.06.87

(51) Int. Cl.⁴: **H 03 K 19/003,** H 03 K 19/094

(21) Anmeldenummer: **83102543.2**

(22) Anmeldetag: **15.03.83**

(54) **Tristate-Treiberschaltung.**

(30) Priorität: **29.03.82 US 362828**

(43) Veröffentlichungstag der Anmeldung:
**05.10.83 Patentblatt 83/40**

(45) Bekanntmachung des Hinweises auf die Patenterteilung:
**24.06.87 Patentblatt 87/26**

(84) Benannte Vertragsstaaten:
**DE FR GB**

(56) Entgegenhaltungen:
**GB - A - 2 005 935**

**IBM TECHNICAL DISCLOSURE BULLETIN, Band 16, Nr. 8, Januar 1974, Seiten 2677-2678, New York; USA; W.R. KRAFT et al.: "Tristate driver utilizing bipolar-complementary metal-oxide semiconductor technology"**
**IBM TECHNICAL DISCLOSURE BULLETIN, Band 25, Nr. 7A, Dezember 1982, Seiten 3496-3497, New York, USA; E.H. MILLHAM: "Tri-state driver protection"**

(73) Patentinhaber: **International Business Machines Corporation, Old Orchard Road, Armonk, N.Y. 10504 (US)**

(72) Erfinder: **Moser, John Jacob, Jr., 6 Rustic Drive, Essex Junction Vermont 05452 (US)**

(74) Vertreter: **Neuland, Johannes, Dipl.-Ing., Schönaicher Strasse 220, D-7030 Böblingen (DE)**

## Beschreibung

Die Erfindung bezieht sich auf eine Tristate-Treiberschaltung mit zwei in Reihe liegenden Ausgangstransistoren, an deren den Schaltungsausgang bildenden Verbindungspunkt eine kapazitive Last angeschlossen ist, der drei verschiedene Signalpegel zuführbar sind.

Die Entwerfer logischer Schaltungen wissen, dass die Verwendung von Tristate-Treiberschaltungen Vorteile beim Entwurf von Rechen- und Datenverarbeitungssystemen bietet, die sogenannte Sammelleitungs- oder Bus-Architekturen verwenden.

Die gegenwärtige Bus-Architektur für Tristate-Treiberschaltungen erfordert aufgrund der hohen Streukapazität des Busses Treiberschaltungen, die hohe Ströme liefern, grosse Datenübertragungsgeschwindigkeiten und grosse statische Gleichströme für die Empfänger ermöglichen. Obgleich es bekannt ist, dass die Verwendung solcher Tristate-Treiberschaltungen dem Entwerfer von Bus-Architekturen, Rechen- und Datenverarbeitungssystemen Vorteile bietet, haben sie keine weite Verbreitung gefunden.

Im allgemeinen haben Begrenzungen und die Anzahl der Eingabe-/Ausgabestifte für ein Halbleiterchip die Produktentwerfer dazu geführt, bidirektionale Busse zu verwenden, um die verfügbaren Eingabe-/Ausgabestifte möglichst wirksam auszunutzen. Diese Verwendung bidirektionaler Busse basiert auf der Voraussetzung, dass zu jedem gegebenen Zeitpunkt nur ein Halbleiterchip Informationen zu anderen Halbleiterchips innerhalb des Systems sendet. Jedoch sind mehrere solcher Tristate-Treiberschaltungen mit einem einzigen Bus in der Architektur verbunden, und unter bestimmten Bedingungen können zwei oder mehr Treiberschaltungen unbeabsichtigt und gleichzeitig in entgegengesetzte logische Pegel geschaltet werden. Es könnte beispielsweise ein erstes Halbleiterchip versuchen, dem Bus eine 1-Bedingung aufzuzwingen, während ein zweites Halbleiterchip, das mit der gleichen Leitung gekoppelt ist, versucht, der Leitung eine 0-Bedingung aufzuzwingen. Dies führt nicht nur dazu, dass die Information auf dem Bus zerstört wird, sondern auch zur Zerstörung der Treiberschaltungen. Die Verwendung solcher Treiberschaltungen in einer Bus-Architektur ist daher durch die Tatsache verhindert worden, dass Systemausfälle oder Programmierfehler zur Zerstörung der Treiberschaltungen führen können.

Diese Situation, in der zwei Halbleiterchips versuchen, gleichzeitig verschiedene oder entgegengesetzte logische Daten auf dem gleichen bidirektionalen Bus zu senden, wird als orthogonale Bedingung bezeichnet. Im Idealfall sollte natürlich eine solche Orthogonalitätsbedingung in dem System nie auftreten und kann durch ein striktes Kommunikationsprotokoll innerhalb des Systems vermieden werden. Jedoch kann ein Programmfehler in dem Protokollprogramm das gesamte System beschädigen. Darüber hinaus kann in solchen Systemen nicht auf solche Fehler geprüft werden, die nicht ohne das Herbeiführen orthogonaler Zustände erkannt werden können. Daher kann es unter bestimmten Bedingungen notwendig werden, das Protokoll zu umgehen, um das System vollständig zu testen. Solche Beschädigungen sind besonders ernst für die Systemarchitektur, da ein Ausfall innerhalb der Schaltung für das Kommunikationsprotokoll nicht nur die Tristate-Treiberschaltung auf dem Chip zerstören kann, sondern auch eine andere auf einem anderen Chip, und ein Ersatz der beschädigten Bauteile löst das Problem nicht, wenn nicht der ursprüngliche Fehler vollständig diagnostiziert und eliminiert ist.

Eine Tristate-Treiberschaltung gemäss dem Obergriff des Anspruchs 1 ist aus der GB-A-2 005 935 bekannt. Diese Schaltung ist zwar gegen Überstrom geschützt, benötigt dazu aber zusätzlich Sensor- und Steuerschaltungen.

Hier will die Erfindung Abhilfe schaffen. Die Erfindung, wie sie in den Ansprüchen gekennzeichnet ist, löst die Aufgabe, eine Tristate-Treiberschaltung anzugeben, die bei Verbindung mit einer anderen Tristate-Treiberschaltung über einen Bus durch eine Orthogonalitätsbedingung nicht zerstört wird und trotz verringerter Verlustleistung eine hohe Schaltgeschwindigkeit besitzt. Aufgrund ihrer Eigenschaft, durch Orthogonalitätsbedingungen nicht zerstört zu werden, ermöglicht die Treiberschaltung nach der Erfindung auch eine verbesserte Prüfbarkeit auf Fehler in einem Datenverarbeitungssystem.

Im folgenden wird die Erfindung in Verbindung mit den Zeichnungen näher erläutert, von denen zeigen:

Fig. 1 ein Schaltbild eines ersten Ausführungsbeispieles der Erfindung,

Fig. 2 ein Schaltbild eines zweiten Ausführungsbeispieles der Erfindung.

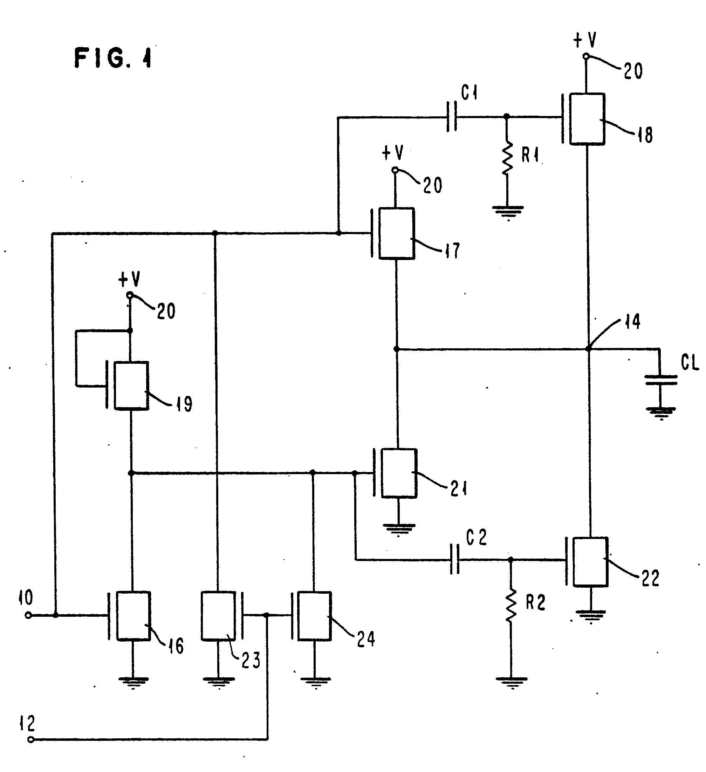

In Fig. 1 ist eine Tristate-Treiberschaltung gemäss der Erfindung dargestellt, die mit Feldeffekttransistoren (FET) aufgebaut ist. Die Treiberschaltung nach der Erfindung enthält einen ersten Eingang 10, dem positive oder negative Datensignale zugeführt werden können und einen zweiten Eingang 12, dem ein Signal zum Unwirksammachen der Schaltung zugeführt werden kann. Ein Ausgang 14, an dem das Ausgangssignal der drei Pegel erzeugenden Schaltung abgenommen wird und der mit einem Bus verbunden sein kann, ist ebenfalls vorgesehen.

Die erste Eingangsklemme 10 ist direkt mit der Gate-Elektrode eines zu einem Inverter gehörenden FET 16 und mit der Gate-Elektrode eines Transistors 17, der einen niedrigen Strom liefert, eine hohe Impedanz aufweist und ein positives Ausgangssignal erzeugt, direkt verbunden und kapazitiv über einen Kondensator C1 mit der Gate-Elektrode eines Transistors 18 gekoppelt, der einen hohen Strom liefert, eine niedrige Impedanz aufweist und ein positives Ausgangssignal liefert. Die Drain-Elektrode des Transistors 16 ist mit dem Massepotential und seine Source-Elektrode über einen als Lastelement 19 dienenden FET an den positiven Pol einer Betriebsspannungsquelle 20 angeschlossen. Die Source-Elektrode des Transistors 16 ist ebenfalls direkt mit der Gate-Elektrode eines Transistors 21, der einen niedrigen Strom liefert, eine hohe Impedanz aufweist und ein negatives Ausgangssignal erzeugt, direkt gekoppelt und kapazitiv über einen Kondensator C2 mit der Gate-Elektrode eines Transistors 22, der einen hohen Strom liefert, eine niedrige Impedanz aufweist und ein negatives Ausgangssignal erzeugt.

Die Source-Elektroden der Transistoren 17 und 18 sind ebenfalls mit dem positiven Pol der Betriebsspannungsquelle 20 verbunden, während ihre Drain-Elektroden mit dem Ausgang 14 verbunden sind. Umgekehrt sind die Source-Elektroden der Transistoren 21 und 22 mit dem Ausgang 14 verbunden und ihre Drain-Elektroden mit Masse. Ausserdem sind die Gate-Elektroden der einen hohen Strom liefernden Transistoren 18 und 22 über die Widerstände R1 und R2 an Masse angeschlossen. Der Eingang 12 zum Umwirksammachen der Treiberschaltung ist mit den Gate-Elektroden der Transistoren 23 und 24 verbunden, deren Drain-Elektroden an Masse angeschlossen sind und deren Source-Elektroden mit den Gate-Elektroden der Ausgangstransistoren 17 und 18 bzw. 21 und 22 verbunden sind.

Für die Beschreibung der Wirkungsweise der Schaltung wird angenommen, dass das dem Eingang 10 zugeführte Datensignal ein Impuls ist, der von 0 V auf +5 V ansteigt. Es sei jedoch bemerkt, dass andere Spannungen und Bereiche ebenso verwendet werden können, wie das den Schaltungsentwerfern wohl bekannt ist. Wenn das Eingangssignal auf den Wert +5 V ansteigt, werden die Transistoren 16, 17 und 18 leitend. Den Gate-Elektroden der Transistoren 16 und 17 wird das Eingangssignal direkt zugeführt, während dem Gate des Transistors 18 aufgrund des Kondensators C1 nur die Wechselstromkomponente des Signals zugeführt wird. Wenn der Transistor 16 leitend wird, zieht er die Spannung an den Gate-Elektroden der Transistoren 21 und 22 nach Masse auf den Wert 0 V herunter, wodurch die Transistoren 21 und 22 nichtleitend werden. Wenn die Transistoren 17 und 18 leitend werden, beginnen sie Strom an den Ausgang 14 zu liefern und machen das Ausgangspotential positiv. Der Transistor 18 ist ein Leistungstransistor, um einen hohen Ausgangsstromstoss zu liefern, der erforderlich ist, um den Ausgang 14 auf den richtigen neuen Spannungspegel zu bringen. Die vorherrschende Belastung des Ausgangs 14 durch den Bus ist durch den Kondensator CL dargestellt und erhält einen hohen Anfangsstromstoss, um den Spannungspegel zu ändern. Wenn der Ausgang 14 durch diesen hohen anfänglichen Stromstoss auf die gewünschte Spannung aufgeladen worden ist, ist nur sehr wenig Gleichstrom erforderlich, um den Spannungspegel aufrechtzuerhalten. Daher kann der den hohen Strom liefernde Transistor 18 abgeschaltet werden. Das RC-Netzwerk aus dem Kondensator C1 und R1 sorgt dafür durch Verringern der Gate-Spannung des Transistors 18 mit einer bekannten Geschwindigkeit, die von der Grösse von R1 und C1 abhängt. Obgleich der Transistor 18 nichtleitend wird, bleibt der Transistor 17, dessen Gate-Elektrode der Gleichstromanteil des Datensignals zugeführt wird, leitend und liefert den notwendigen niedrigen Gleichstrom, der erforderlich ist, um den erwünschten Spannungspegel am Ausgang 14 aufrechtzuerhalten. Daher bietet der Transistor 18 einen Pfad mit niedriger Impedanz für einen hohen Strom für den anfänglichen Stromstoss, welcher Pfad automatisch gesperrt wird, nachdem der anfängliche Stromstoss abgeklungen ist.

Der Transistor 16 wird, wenn die seiner Gate-Elektrode zugeführte Spannung auf 0 V verringert wird, gesperrt, was es dem Transistor 19 erlaubt, einen postiven Spannungsimpuls den Gate-Elektroden der Transistoren 21 und 22 zuzuführen, wodurch diese Transistoren leitend werden. Wenn der Transistor 22 leitend wird, fliesst ein grosser Stromstoss durch diesen Transistor nach Masse und zieht die Spannung des Ausgangs 14 schnell auf den gewünschten Wert herunter. Wieder wird wegen des RC-Kopplungsnetzwerkes aus dem Kondensator C2 und dem Widerstand R2 die Gate-Spannung des Transistors 22 auf Massepotential gebracht, um den Transistor 22 auszuschalten, während der Gleichstromanteil, der der Gate-Elektrode des Transistors 21 über den Transistor 19 zugeführt wird, dafür sorgt, dass der Transistor 21 leitend bleibt und fortfährt, das Potential des Ausgangs 14 niedrig zu halten. Wie vorher dargelegt, besitzt der Transistor 22 einen Pfad niedriger Impedanz für die notwendigen hohen Stromstösse, die auftreten, während das Potential des Ausgangs 14 auf einen niedrigen Pegel geschaltet wird. Wenn ein positives Signal dem Eingang 12 zum Unwirksammachen der Treiberschaltung zugeführt wird, werden die Transistoren 23 und 24 leitend und verbinden dadurch die Gate-Elektroden der Ausgangstransistoren 17 und 21 mit Masse, wordurch diese Transistoren nichtleitend werden und den Ausgang 14 isolieren. Dies verhindert es, dass die Ausgangsspannung durch irgendeinen der Ausgangstransistoren 17, 18, 21 oder 22 auf einem Wert festgehalten wird, so dass das Potential des Ausgangs 14 abhängig von der Last CL hinauf- oder hinuntergleitet. Daher nimmt der Ausgang 14 seinen dritten oder unbestimmten Zustand an.

Daher ist die anhand der Fig. 1 beschriebene Tristate-Treiberschaltung eine, bei der sich ihre Ausgangsimpedanz in dynamischer Weise während der Spannungsübergänge am Ausgang ändert. Die dynamischen Ausgangstransistoren 18 und 22 sorgen für Pfade niedriger Impedanz für die hohen Stromstösse, die erforderlich sind, um die Ausgangsleitung schnell auf die gewünschten Spannungspegel zu laden oder zu entladen, während die Transistoren 17 und 21, die eine hohe Impedanz besitzen und niedrige Ströme liefern, einen Gleichstrom aufrechterhalten, der notwendig ist, um den Pegel des Ausgangs 14 auf dem gewünschten Wert zu halten.

Die beschriebene Schaltung ist für alle gegenwärtigen Anwendungen für Tristate-Treiberschaltungen geeignet, ohne dass sie den Nachteil des Ausbrennens während der sogenannten Orthogonalitätsbedingungen aufweist, die früher beschrieben wurden. Kein Ausfall der Logik innerhalb des Systems verursacht, dass ein Tristate-Treiber, der gemäss der Erfindung aufgebaut ist, ausbrennt oder in anderer Weise beschädigt wird. Darüber hinaus kann der Testumfang solcher Systeme vergrössert werden, da jetzt auf Fehler geprüft werden kann ohne Rücksicht auf die Ausgangssignale, die durch die Testmuster erzeugt werden.

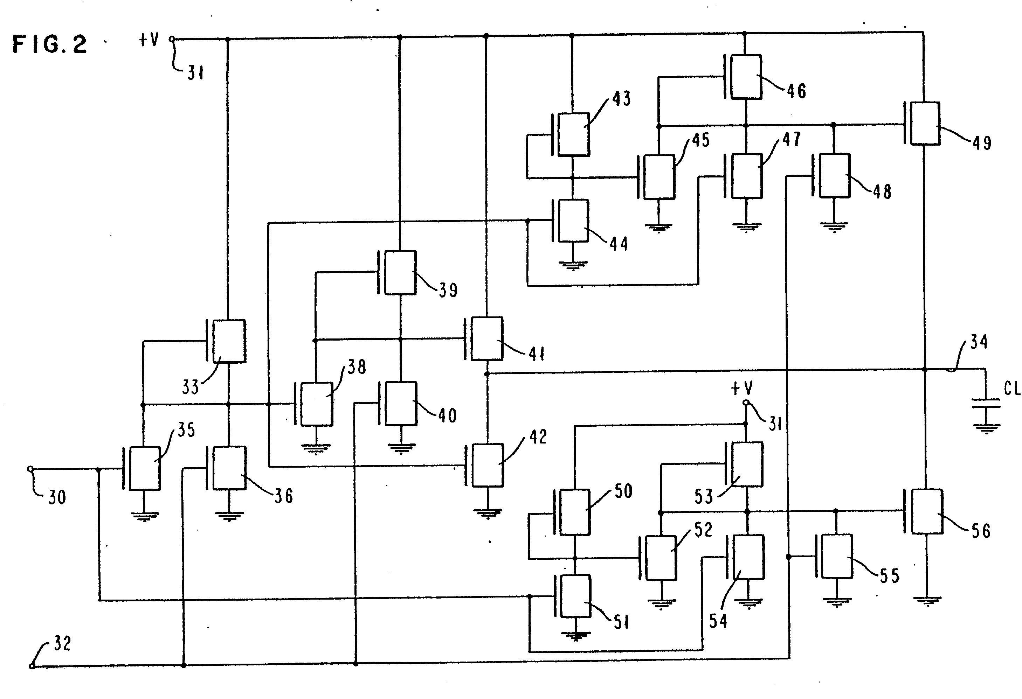

Fig. 2 zeigt eine andere Schaltung, die sicherstellt, dass der ausgewählte Ausgangstransistor, der von einem hohen Strom durchflossen wird und eine niedrige Impedanz besitzt, leitend wird, bevor der ausgewählte Ausgangstransistor für den Gleichstrom leitend wird. Wieder sind in der Figur Feldeffekttransistoren dargestellt; die Schaltung ist mit einem Dateneingang 30 versehen, einem Eingang 32 zum Unwirksammachen der Schaltung und einem Ausgang 34, an den eine kapazitive Last angeschlossen ist, die wieder als Kondensator CL dargestellt ist.

Bei dieser Schaltung ist die Dateneingangsleitung 30 direkt mit den Gate-Elektroden der Transistoren 35, 51 und 54 verbunden, deren Drain-Elektroden mit Masse verbunden sind. Die Source-Elektrode jedes dieser Transistoren ist an den positiven Pol einer Betriebsspannungsquelle 31 über einen als Lastelement dienenden Feldeffekttransistor 33, 50 und 53 angeschlossen. Die Source-Elektrode des Transistors 35 ist auch mit den Gate-Elektroden der Transistoren 38, 42, 44 und 47 verbunden.

Die Drain-Elektrode jedes dieser Transistoren 38, 42, 44 und 47 ist an Masse angeschlossen. Die Source-Elektroden der Transistoren 38, 44 und 47 sind über als Lastelemente dienende Feldeffekttransistoren 39, 43 und 46 an den positiven Pol der Betriebsspannungsquelle 31 angeschlossen. Die Source-Elektrode des Transistors 38 ist auch mit der Gate-Elektrode eines eine hohe Impedanz aufweisenden und einen Gleichstrom liefernden Ausgangstransistors 41 und der Source-Elektrode eines Transistors 40 zum Unwirksammachen der Schaltung verbunden. Der Transistor 42 ist auch ein Ausgangstransistor mit hoher Impedanz, dessen Source-Elektrode mit der Ausgangsleitung 34 verbunden ist. Die Source-Elektrode des Transistors 44 ist auch an die Gate-Elektrode eines Transistors 45 angeschlossen, dessen Source-Elektrode mit den Source-Elektroden der Transistoren 47 und 48 und mit der Gate-Elektrode eines eine niedrige Impedanz aufweisenden und einen hohen Strom liefernden Ausgangstransistors 49 verbunden ist.

Die Source-Elektrode des Transistors 51 ist mit der Gate-Elektrode des Transistors 52 verbunden, dessen Drain-Elektrode an Masse liegt und dessen Source-Elektrode mit der Source-Elektrode der Transistoren 54 und 55 und der Gate-Elektrode eines eine niedrige Impedanz aufweisenden und einen hohen Strom ziehenden Ausgangstransistors 56 verbunden ist, dessen Source-Elektrode an die Ausgangsleitung 34 angeschlossen ist.

Die Leitung 32 zum Unwirksammachen der Schaltung ist mit den Gate-Elektroden der Transistoren 36, 40, 48 und 55 verbunden.

Die Schaltung arbeitet in folgender Weise: Ein positives Signal wird den Gate-Elektroden der Transistoren 35, 51 und 54 zugeführt und macht diese leitend. Dadurch werden die Gate-Elektroden der Transistoren 38, 42, 44, 47, 52 und 56 mit Masse verbunden, und diese Transistoren werden nichtleitend. Wenn die Transistoren 42 und 56 nichtleitend werden, ist die Ausgangsleitung 34 nicht länger mit Masse verbunden und jetzt in der Lage, eine positive Spannung anzunehmen.

Wenn Transistor 47 nichtleitend wird, nimmt die Gate-Elektrode des Transistors 49 über den als Lastelement wirkenden Transistor 46 eine positive Spannung an. Dies führt dazu, dass der eine niedrige Ausgangsimpedanz aufweisende und einen hohen Strom führende Ausgangstransistor 49 leitend wird und die Ausgangsleitung 34 eine positive Spannung annimmt.

Der Transistor 45 bleibt für den Zeitraum, den der Transistor 44 benötigt, um voll gesperrt zu werden, nichtleitend. Wenn der Transistor 44 völlig gesperrt ist, wird der Transistor 45 leitend und verbindet die Gate-Elektrode des Transistors 49 mit Masse und macht diesen Transistor nichtleitend.

Der Transistor 49 wird daher vor dem Transistor 41 leitend. Da die Transistoren 48 und 44 zusammen nichtleitend werden, werden die Transistoren 41 und 45 gleichzeitig leitend, und der Transistor 41 beginnt einen Gleichstrom zu liefern, um die Ausgangsleitung 34 auf ihrem Pegel zu halten, wenn der Transistor 49 nichtleitend zu werden beginnt aufgrund der Verbindung seiner Gate-Elektrode mit Masse über den leitenden Transistor 45.

Die Schaltung stellt sicher, dass der Ausgangstransistor 49, der einen hohen Strom führt und eine niedrige Impedanz aufweist, vor dem Transistor 41 leitend wird. Daher wird das Ausbrennen des eine niedrige Impedanz aufweisenden Ausgangstransistors 49 aufgrund eines übermässigen Stromflusses vermieden.

Wenn ein negatives Spannungssignal den Gate-Elektroden der Transistoren 35, 51 und 54 zugeführt wird, werden diese Transistoren nichtleitend und die Gate-Elektroden der Transistoren 38, 42, 44, 47, 52 und 56 erhalten ein positives Potential, und diese Transistoren beginnen alle zu leiten. Da der Transistor 56, der eine niedrige Impedanz aufweist und von einem hohen Strom durchflossen wird, für einen Zeitraum leitend bleiben muss, der ausreicht, die Ausgangsleitung 34 anfänglich zu entladen, sollte der Transistor 52 so entworfen sein, dass er langsamer leitend wird als der Transistor 56. Wenn ein geeigneter Transistor nicht entworfen werden kann, können zusätzliche Transistoren zwischen den Transistoren 51 und 52 vorgesehen werden, um sicherzustellen, dass das Einschalten des Transistors 52 verzögert wird.

Wenn der Transistor 52 leitend wird, wird der Transistor 56 nichtleitend.

Wenn ein positives Signal für das Unwirksammachen der Schaltung am Eingang 32 vorhanden ist, werden die Transistoren 36, 40, 48 und 55 alle leitend und machen die Ausgangstransistoren 41, 42, 49 und 56 nichtleitend und verhindern, dass die Ausgangsleitung 34 auf einem Spannungswert festgehalten wird, so dass das Potential der Leitung 34 abhängig von der Last CL, die mit der Ausgangsleitung 34 verbunden ist, hinauf- oder hinuntergleitet und sich die Treiberschaltung in ihrem unbestimmten oder dritten Zustand befindet.

**Patentansprüche**

1. Tristate-Treiberschaltung mit zwei in Reihe liegenden Ausgangstransistoren, an deren den Schaltungsausgang bildenden Verbindungspunkt eine kapazitive Last (CL) angeschlossen ist, dadurch gekennzeichnet, dass parallel zur Schaltstrecke jedes Ausgangstransistors (18, 22 bzw. 49, 56) die Schaltstrecke eines zusätzlichen Ausgangstransistors (17, 21 bzw. 41, 42) liegt, der nach einer Änderung des Ausgangspotentials der Treiberschaltung durch den anschliessend gesperrten Ausgangstransistor das Aufrechterhalten des geänderten Ausgangspotentials übernimmt.

2. Tristate-Treiberschaltung nach Anspruch 1, dadurch gekennzeichnet, dass die Steuerelektroden der bezüglich ihrer Schaltstrecken parallel liegenden Ausgangstransistoren (17, 18 bzw. 21, 22) über ein differenzierendes RC-Glied (C1, R1, bzw. C2, R2) miteinander verbunden sind.

3. Treiberschaltung nach Anspruch 2, dadurch gekennzeichnet, dass der eine (18 bzw. 22) der beiden bezüglich ihrer Schaltstrecken parallel geschalteten Ausgangstransistoren (17, 18 bzw. 21, 22) ein Transistor ist, der im leitenden Zustand eine niedrige Impedanz aufweist, und der aufgrund des ihm von dem RC-Glied zugeführten differenzierten Steuerimpulses kurzzeitig von einem hohen Stromstoss zur Änderung des Ausgangspotentials der Treiberschaltung durchflossen wird, wogegen der andere bezüglich seiner Schaltstrecke parallel liegende Ausgangstransistor (17 bzw. 21) im leitenden Zustand eine hohe Impedanz besitzt und einen niedrigen Strom zum Aufrechterhalten des Ausgangspotentials nach dem Nichtleitendwerden des anderen Ausgangstransistors führt.

4. Treiberschaltung nach Anspruch 1 oder 2, dadurch gekennzeichnet, dass die Transistoren Feldeffekttransistoren sind.

5. Treiberschaltung nach Anspruch 1 oder 2, dadurch gekennzeichnet, dass die Transistoren Bipolartransistoren sind.

**Claims**

1. Tristate driver circuit with two series-arranged output transistors to whose point of connection forming the circuit output a capacitor load (CL) is connected, characterized in that in parallel to the circuit path of each output transistor (18, 22 or 49, 56) the circuit path of an additional output transistor (17, 21 or 41, 42) is provided which after a change of the output potential of the driver circuit by the subsequently deactivated output transistor takes over the maintenance of the changed output potential.

2. Tristate driver circuit as claimed in claim 1, characterized in that the control electrodes of the output transistors (17, 18 or 21, 22) arranged in parallel with respect to their circuit paths are interconnected via a differentiating RC element (C1, R1, or C2, R2).

3. Driver circuit as claimed in claim 2, characterized in that the one (18 or 22) of the two output transistors (17, 18 or 21, 22) arranged in parallel with respect to their circuit paths is a transistor which in its conductive state has a low impedance, and which owing to the differentiated control impulse applied thereto by the RC element transports, for a short period, a high current surge to change the output potential of the driver circuit, whereas the other output transistor (17 or 21) arranged in parallel with respect to its circuit path has a high impedance in its conductive state, and transports a low current to maintain the output potential after the other output transistor has been rendered non-conductive.

4. Driver circuit as claimed in claim 1 or 2, characterized in that the transistors are filed effect transistors.

5. Driver circuit as claimed in claim 1 or 2, characterized in that the transistors are bipolar transistors.

**Revendications**

1. Circuit de commande à trois états comportant deux transistors de sortie disposés en série et dont le point de jonction, formant la sortie de circuit, est relié à une charge capacitive (CL), caractérisé en ce qu'il est prévu en parallèle à la voie de commutation de chaque transistor de sortie (18, 22 ou 49, 56) la voie de commutation d'un transistor de sortie additionnel (17, 21 ou 41, 42), qui assure, après une variation du potentiel de sortie du circuit de commande, le maintien du potentiel de sortie modifié au moyen du transistor de sortie bloqué ensuite.

2. Circuit de commande à trois états selon la revendication 1, caractérisé en ce que les électrodes de commande des transistors de sortie (17, 18 ou 21, 22), dont les voies de commutation sont branchées en parallèle, sont reliées entre elles par l'intermédiaire d'un composant-RC de différenciation (C1, R1 ou C2, R2).

3. Circuit de commande selon la revendication 2, caractérisé en ce qu'un (18 ou 22) des deux transistors (17, 18 ou 21, 22) branchés en parallèle en ce qui concerne leurs voies de commutation est un transistor qui a une faible impédance dans la condition de conduction et qui, sous l'effet que l'impulsion de commande différenciée appliquée par le composant-RC, est traversé pendant une courte durée par une forte impulsion de courant pour modifier le potentiel de sortie du circuit de commande alors que par contre l'autre transistor de sortie (17 ou 21), branché en parallèle par sa voie de commutation a une grande impédance dans la condition de conduction et conduit un courant faible pour maintenir le potentiel de sortie après le blocage de l'autre transistor de sortie.

4. Circuit de commande selon la revendication 1 ou 2, caractérisé en ce que les transistors sont des transistors à effets de champ.

5. Circuit de commande selon la revendication 1 ou 2, caractérisé en ce que les transistors sont des transistors bipolaires.

**FIG. 1**

FIG.2